# FASCICULE DE BREVET EUROPEEN

(11) **EP 3 170 375 B1**
(45) Date de publication et mention de la délivrance du brevet: **12.09.2018**
(21) Numéro de dépôt: 15759500.0
(22) Date de dépôt: 09.07.2015
(51) Int. Cl.: H05K 1/05, H05K 3/34, H05K 7/20, H05K 7/14

(54) **CONVERTISSEUR DE PUISSANCE DE COURANT CONTINU EN COURANT ALTERNATIF**
GLEICHSTROM-/WECHSELSTROMWANDLER
DC/AC POWER CONVERTER

(30) Priorité: 15.07.2014 FR 1456793
(43) Date de publication de la demande: 24.05.2017
(73) Titulaire: Valeo Equipements Electriques Moteur, 94046 Créteil Cedex (FR)
(72) Inventeur: GUERIN, Fabien, Créteil Cedex F-94046 CRETEIL (FR); CANCIANI, Thierry, F-78600 Maisons Laffitte (FR); DUARTE, Johnny, F-94046 CRETEIL (FR)
(74) Mandataire: Novembre, Christophe Adelphe
(86) Numéro de dépôt international: PCT/FR2015/051898
(87) Numéro de publication internationale: WO 2016/009133

(56) Documents cités:
- ES-A1- 2 177 444
- GB-A- 2 471 497
- US-A1- 2006 039 127
- US-A1- 2009 154 101
- US-A1- 2013 093 296

## Description

La présente invention concerne un dispositif d'alimentation d'un compresseur de suralimentation électrique.

Des considérations écologiques, et notamment la lutte contre le réchauffement climatique en réduisant les émissions de CO₂, ont amené les équipementiers à proposer aux constructeurs d'automobiles des compresseurs de suralimentation électriques qui améliorent la réponse dynamique des moteurs à combustion interne de faible cylindrée à bas régime.

A la différence des compresseurs de suralimentation classiques entraînés par les gaz d'échappement, le compresseur de suralimentation électrique, c'est-à-dire entraîné par un moteur électrique, présente un temps de réponse instantané, et améliore le couple moteur à bas régime et l'accélération.

Ce système permet de réduire considérablement la cylindrée des moteurs thermiques, et par conséquent de réduire la consommation de carburant.

Dans le cas d'un moteur diesel, le temps de latence d'un compresseur de suralimentation à gaz est aussi responsable de l'émission de particules quand, dans une phase d'accélération à bas régime, le système d'injection essaie de fournir la puissance demandée en injectant un surplus de carburant.

Pour pallier cet inconvénient, la société VALEO SYSTEMES DE CONTROLE MOTEUR propose dans sa demande de brevet internationale WO 2013/045821 la mise en oeuvre d'un compresseur de suralimentation électrique pour assister le turbocompresseur à gaz au moment de l'enfoncement de la pédale d'accélérateur.

Compte tenu des niveaux de puissance requis, les convertisseurs utilisés dans ces applications ne sont plus réalisés sous forme de modules intégrant des composants électroniques sur des circuits imprimés en époxy (de type FR4), mais font appel à la technologie des substrats métalliques isolés (SMI) qui permet une meilleure dissipation thermique des composants de puissance.

Le document GB 2471497 A décrit un convertisseur faisant appel à la technologie des substrats métalliques isolés (SMI)

Par ailleurs, le document US 2009/0154101 A1 décrit un convertisseur selon le préambule de la revendication 1.

Les éléments de stockage d'énergie électrique - selfs ou condensateurs - mis en oeuvre dans des convertisseurs de puissance sont des composants dits « traversants ».

Comme l'étaient les connecteurs, ces composants traversants sont difficiles à souder sur un substrat métallique isolé en termes de procédé et ne peuvent pas être intégrés sur un substrat métallique isolé comme sur un circuit imprimé en époxy, car cela conduirait à des risques de court-circuit.

Ces selfs et/ou condensateurs des convertisseurs de puissance connus de l'état de technique sont donc placés à côté du substrat métallique isolé et reliés aux pistes de celui-ci par des traces de liaison (formées dans de la tôle de cuivre découpée) surmoulées dans une pièce intermédiaire.

Toutefois, dans certains modes de réalisation d'un tel système, la surface allouée pour l'électronique est limitée dans un diamètre défini. Placer les composants de puissance sur le côté de la carte devient alors difficile.

La présente invention vise à pallier les inconvénients mentionnés ci-dessus, en particulier en fournissant un dispositif d'alimentation d'un compresseur de suralimentation électrique.

A cet effet, la présente invention a pour objet un convertisseur de puissance de courant continue en courant alternatif, ledit convertisseur comprenant une carte électronique de puissance réalisée sur une substrat métallique isolé comprenant :
- un support métallique formant face arrière dudit substrat métallique isolé, et
- une couche d'isolant recouvrant le support métallique, formant face avant dudit substrat métallique isolé,
dans lequel au moins un composant est monté sur la face arrière du substrat métallique isolé.

Avantageusement, l'arrangement du convertisseur de puissance selon l'invention permet de pallier le problème de placer des composants sur une surface limitée, quand le routage de la carte électronique restreint les emplacements possible, laissant ainsi une plus grande liberté de placement. Cela permet également la mise en place de composants sous le substrat métallique isolé et de les souder sur ledit substrat métallique isolé sans risque de court-circuit.

Le dispositif d'alimentation d'un compresseur de suralimentation électrique selon l'invention peut également comprendre une ou plusieurs des caractéristiques ci-dessous, considérées individuellement ou selon toutes les combinaisons techniquement possibles :
- le substrat métallique isolé comprend des pistes de liaison électrique, lesdites pistes étant disposées sur la couche d'isolant dudit substrat métallique isolé et relient des composants électroniques disposées sur la face avant du substrat métallique isolé ; et/ou
- le composant est relié électriquement à au moins une des pistes de liaison électrique ; et/ou
- le composant comprend des fiches, lesdites fiches traversent le substrat métallique isolé par l'intermédiaire d'un trou débouchant dans ledit substrat métallique isolé ; et/ou
- le au moins un composant monté sur la face arrière du substrat métallique isolé est soudé à au moins une piste de liaison électrique au moyen d'une pièce intermédiaire placée en face avant dudit substrat métallique isolé et permettant de faire l'interface entre ladite au moins une piste de liaison électrique et une fiche du au moins un composant ; et/ou
- la pièce intermédiaire est un assemblage de deux jeux de barres de connexion électrique séparés par une pièce plastique ; et/ou
- le matériau de la pièce plastique est choisi de telle sorte que la pièce plastique résiste à des températures de four de refusions ; et/ou
- l'extrémité d'au moins une barre est en forme de fourche pour accueillir les fiches du composant ; et/ou
- la pièce intermédiaire est un chapeau de soudure engagé par une ouverture sur au moins une des fiches du au moins un composant ; et/ou
- ledit chapeau de soudure est de forme sensiblement parallélépipédique ; et/ou
- ledit chapeau de soudure comporte une partie inférieure présentant une bride s'étendant dans le plan dudit substrat métallique isolé ; et/ou
- ledit chapeau de soudure comporte une paroi présentant au moins un pli ; et/ou
- les pistes de liaison électrique sont des pistes de cuivre.

L'invention concerne aussi un convertisseur de puissance de courant continue en courant alternatif, ledit convertisseur comprenant une carte électronique de puissance réalisée sur un substrat métallique isolé comprenant :
- un support métallique formant face arrière dudit substrat métallique isolé, et
- une couche d'isolant recouvrant le support métallique, formant face avant dudit substrat métallique isolé,
le convertisseur comprenant en outre au moins un composant monté sur la face arrière du substrat métallique isolé,
ledit composant comprenant au moins une fiche qui traverse le substrat métallique isolé par l'intermédiaire d'un trou débouchant dans ledit substrat métallique isolé, et ledit composant étant soudé à au moins une piste de liaison électrique au moyen d'une pièce intermédiaire placée en face avant dudit substrat métallique isolé et permettant de faire l'interface entre ladite au moins une piste de liaison électrique et la fiche du composant.

Le convertisseur selon cette invention peut comprendre l'une quelconque des caractéristiques présentées précédemment et/ou l'une quelconque des caractéristiques ci-dessous :
- le composant comprend plusieurs fiches, lesdites fiches traversent le substrat métallique isolé par l'intermédiaire du trou débouchant dans ledit substrat métallique isolé ;
- ladite piste est disposée sur la couche d'isolant dudit substrat métallique isolé ; notamment, le substrat métallique isolé comprend plusieurs pistes de liaison électrique, et/ou les ou la piste de liaison électrique relie des composants électroniques disposés sur la face avant du substrat métallique isolé ;
- la piste de liaison électrique est une piste de cuivre ; notamment, le substrat métallique isolé comprend plusieurs pistes de liaison électrique, et lesdites pistes sont des pistes de cuivre.

L'invention se rapporte également à un compresseur de suralimentation électrique comprenant un convertisseur de puissance de courant continu en courant alternatif selon l'invention.

L'invention sera mieux comprise à la lumière de la description suivante qui n'est donnée qu'à titre indicatif et qui n'a pas pour but de limiter ladite invention, accompagnée des figures ci-dessous :
- La figure 1 est une vue éclatée d'un compresseur de suralimentation électrique selon l'invention,
- La figure 2 illustre la difficulté d'une soudure d'un élément électronique de type traversant sur un substrat métallique isolé par un procédé de soudure classique,
- La figure 3 représente une méthode de branchement des capacités par déportation par bloc selon un dispositif de l'art antérieur,
- La figure 4 représente un mode de réalisation d'une pièce intermédiaire permettant de faire l'interface entre le routage du substrat métallique isolé et un composant traversant,
- La figure 5 représente le contact entre les fourches d'une pièce intermédiaire et les fiches d'un composant traversant,
- La figure 6 représente une vue de coupe partielle d'un compresseur de suralimentation électrique,
- La figure 7 représente une vue de dessus du dispositif d'alimentation d'un compresseur de suralimentation électrique,
- La figure 8 montre en perspective un chapeau de soudure du type utilisé pour souder les éléments électroniques de type « traversants »,
- La figure 9a montre une variante du chapeau de soudure montré sur la figure 8,
- La figure 9b montre l'ébauche utilisée pour réaliser par pliage le chapeau de soudure comme montré sur la figure 9a,
- La figure 10a illustre le procédé de soudage utilisant le chapeau de soudure présenté en figure 8,
- La figure 10b illustre le procédé de soudage utilisant le chapeau de soudure présenté en figure 9a.

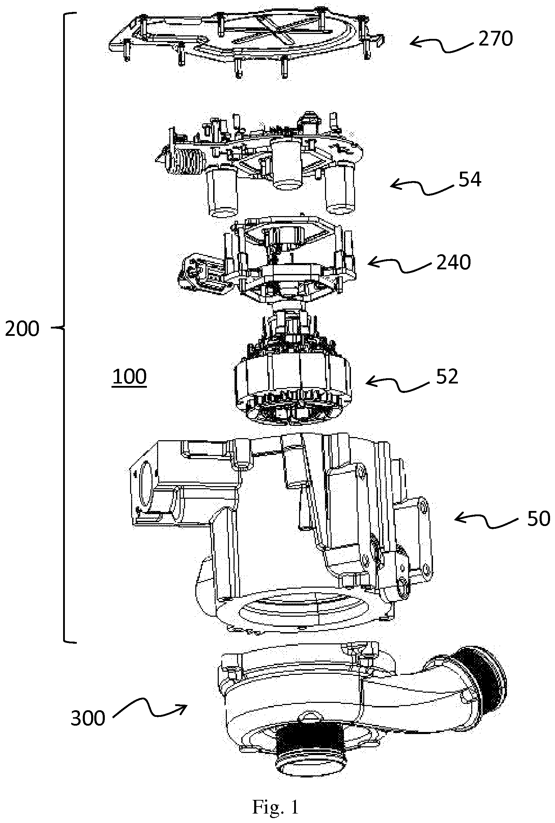

Un exemple de compresseur de suralimentation 100 de véhicule automobile destiné à un système de suralimentation d'un moteur thermique est représenté sur la figure 1.

Comme représenté sur la figure 1, le compresseur de suralimentation 100 comprend une machine électrique tournante 200 et une turbine 300 accouplée à ladite machine électrique tournante 200.

Comme illustré sur la figure 1, la machine électrique tournante 200 comprend un moteur électrique 52 dont les phases sont connectées, par exemple via un dispositif de connexion 240 à une carte électrique de puissance 54. L'ensemble de ces éléments peuvent être disposé à l'intérieur d'un boîtier 50 fermé par un couvercle 270.

Comme cela a déjà été indiqué en préambule, il n'est pas possible de souder des éléments électroniques dont les fiches traversent un substrat métallique isolé directement dessus de la même manière que sur un circuit imprimé en époxy de type FR4.

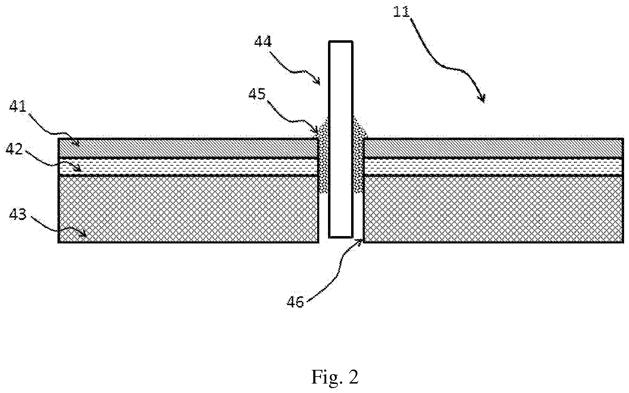

La figure 2 montre la fiche 44 d'un composant traversant placé en face arrière d'un substrat métallique isolé 11 soudée en face avant. Généralement, le substrat métallique isolé 11 est composé de trois couches ou plus : la couche supérieure 41 est en cuivre, la couche intermédiaire 42 est un isolant et la couche inférieure 43 est en aluminium. Le trou débouchant 46 prévu pour laisser passer la fiche 44 à souder dans un substrat métallique isolé 11 doit être plus large pour éviter que la fiche 44 ne rentre en contact avec la couche d'aluminium 43 à la base du substrat métallique isolé 11. Cependant, même si tout contact entre la fiche 44 et la couche d'aluminium 43 est évité, une soudure 45 classique risquerait de migrer par capillarité de la couche de cuivre 41 jusqu'à la couche d'aluminium 43, créant ainsi un court-circuit. Il est donc nécessaire de déporter la soudure pour des composants de types « traversants ».

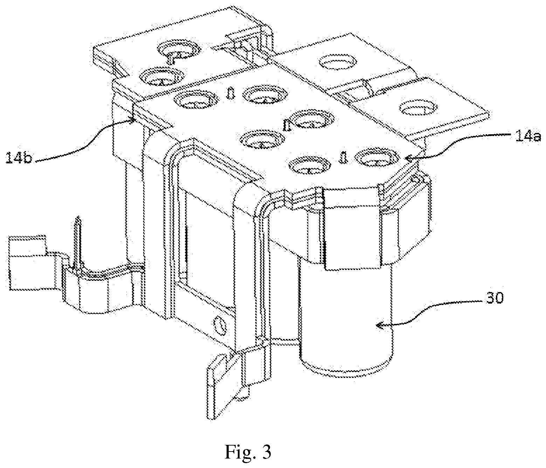

La figure 3 présente une méthode pour faire l'interface entre le substrat métallique isolé 11 et la ou les capacités 30 selon un dispositif de l'art antérieur, dans laquelle la ou les capacités 30 sont déportées en un bloc. Dans le cas où le routage du substrat métallique isolé 11 et l'encombrement ne permet pas de placer les capacités 30 directement au-dessus, une méthode est de déporter les composants pour les placer en dehors de la carte électrique de puissance 54. Le design d'une telle pièce impose que les jeux de barres positif et négatif 14a, 14b soient parallélisés sur la plus longue distance possible, pour répondre aux contraintes de comptabilité électromagnétique et de filtrage.

Cependant, déporter les capacités 30 implique que les jeux de barres 14a, 14b soient plus longs pour relier la piste du substrat métallique isolé 11 aux composants concernés. Les contraintes de parallélisations entrainent un surcout dû à l'augmentation de matière (cuivre) nécessaire à la réalisation des jeux de barres 14a, 14b, ainsi qu'à un échauffement supplémentaire provenant de l'auto échauffement des jeux de barres 14a, 14b.

C'est pourquoi le dispositif de l'invention a pour objet une pièce intermédiaire 10 permettant de relier électriquement les capacités 30 placées en face arrière du substrat métallique isolé 11, et dont les fiches desdites capacités 30 traversent ledit substrat métallique isolé 11 par l'intermédiaire de trous débouchants. Cette pièce intermédiaire 10 a donc pour but de réduire (voire supprimer) les contraintes et inconvénients mentionnés ci-dessus.

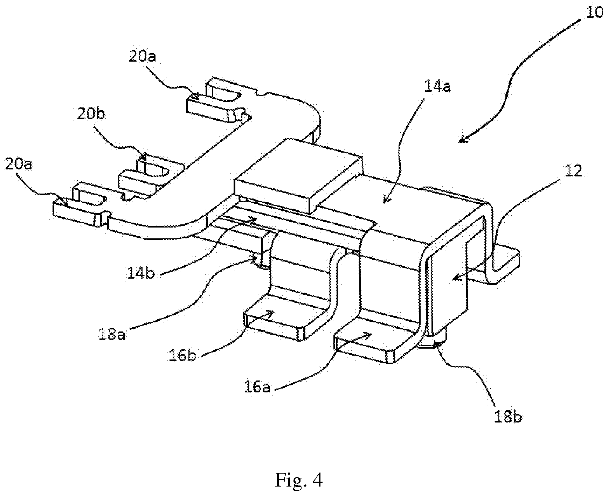

La figure 4 présente une pièce intermédiaire 10 selon l'invention permettant de faire l'interface entre le routage du substrat métallique isolé 11 et une capacité 30. La pièce intermédiaire 10 est composée de deux jeux de barres 14a, 14b (l'un positif, l'autre négatif) assemblés autour d'une pièce plastique 12. Ces jeux de barres 14a, 14b peuvent être fixés à la pièce plastique 12 par bouterollage par exemple, ou bien être directement surmoulés dans la pièce plastique 12. La pièce plastique 12 peut comprendre un ou plusieurs pions d'indexation 18a, 18b, orientés vers le bas de la pièce intermédiaire 10 et vont rejoindre des trous correspondant sur le substrat métallique isolé 11. A l'une des extrémités des jeux de barres 14a, 14b se trouvent des zones plates 16a, 16b permettant le contact avec le substrat métallique isolé 11. Ces zones plates 16a et 16b peuvent former des zones d'appui qui, selon l'épaisseur, permettent de surélever la pièce intermédiaire 10. Le fait de surélever la pièce intermédiaire 10 permet de réaliser les contacts électriques à une distance contrôlée du plan du substrat métallique isolé 11. Les risques de court-circuit avec le substrat sont donc évités, et les extrémités de la pièce intermédiaire sont plus accessibles.

La pièce intermédiaire 10 est donc déposée sur le substrat métallique isolé 11 lors du procédé dit de refusions comme tout autre composant monté en surface, permettant ainsi de faire la liaison électrique entre la pièce intermédiaire 10 et le substrat métallique isolé 11. L'autre extrémité des jeux de barres 14a, 14b est en forme de fourche 20a, 20b, pour assurer la liaison électrique avec la fiche correspondante de la capacité 30. Cette liaison électrique peut se faire par sertissage électrique, ou encore par soudure, mais ne se limite pas à un mode unique de réalisation.

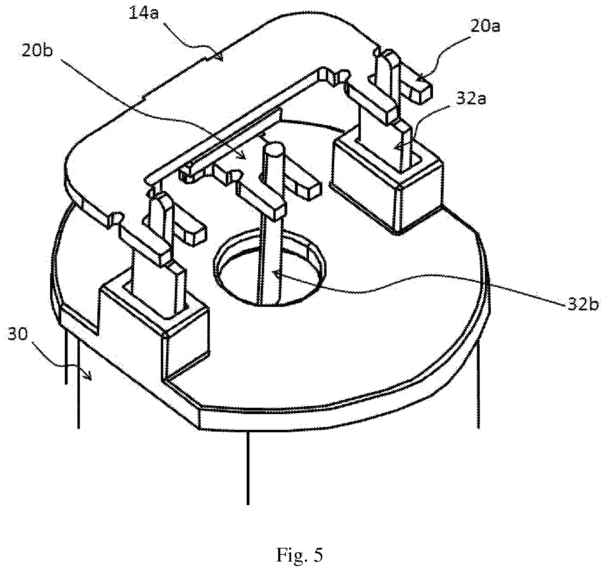

La figure 5 montre les fourches 20a, 20b de la pièce intermédiaire 10 en interaction avec les fiches 32a, 32b de la capacité 30. La forme des fiches 32a, 32b d'une capacité 30 peut être différente de celle montrée en figure 3. La liaison entre les fiches 32a, 32b de la capacité 30 et les fourches 20a, 20b de la pièce intermédiaire 10 peut être réalisée par sertissage électrique, ou par soudure, et n'est pas limitée à un mode unique de réalisation.

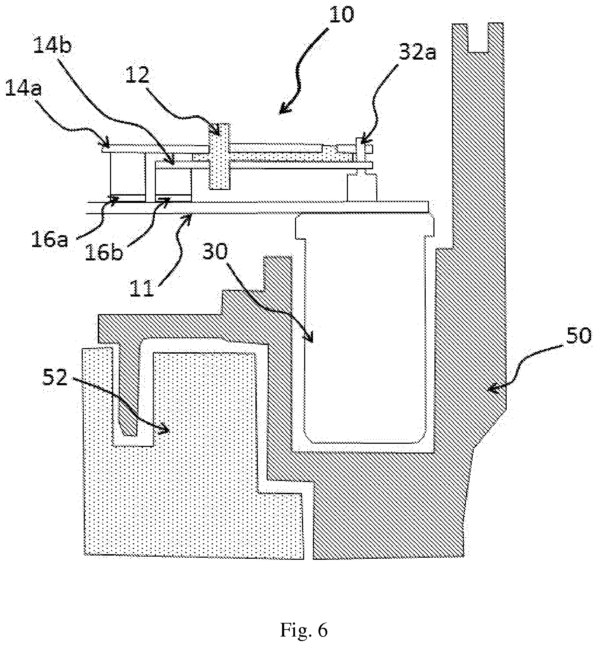

La structure de l'ensemble du compresseur de suralimentation électrique 100 et son boîtier 50 sont adaptées pour permettre le positionnement des capacités 30 en face arrière du substrat métallique isolé 11 et au-dessus du moteur électrique 52 sans impacter la longueur et la largeur totale de l'ensemble, comme le montre la figure 6. Sur ce schéma en coupe de l'ensemble inférieur du compresseur de suralimentation électrique, la pièce intermédiaire 10 déposée sur le substrat métallique isolé 11 est en contact avec les fiches 32a, 32b d'une capacité 30. Les zones plates 16a, 16b à l'extrémité des jeux de barres 14a, 14b sont en contacts avec le substrat métallique isolé 11 permettent de connecter électriquement les capacités 30 au routage du substrat métallique isolé 11.

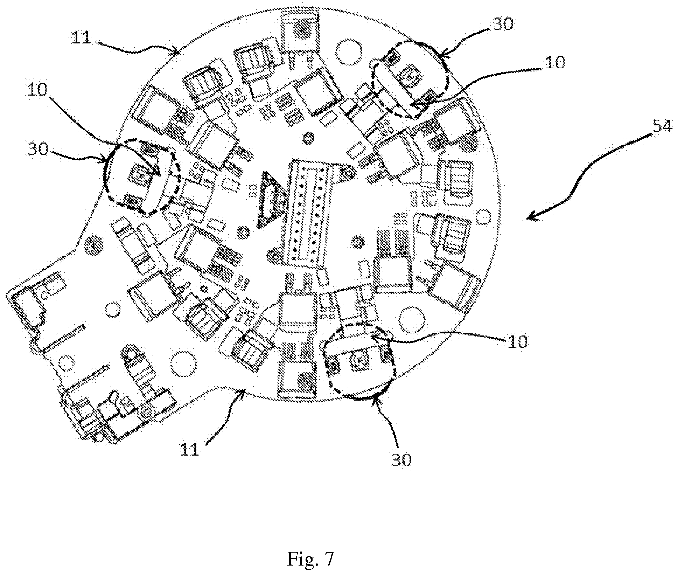

Une vue de dessus de la carte électrique de puissance 54 sur la figure 7 permet de voir les capacités 30 en interaction avec les pièces intermédiaires 10 sur le substrat métallique isolé 11. La vue de haut permet de rendre compte du léger dépassement latéral des capacités 30 par rapport au diamètre du substrat métallique isolé 11. Cependant, dans l'invention telle que présentée, la surface allouée pour la carte électrique de puissance 54 est un disque de diamètre 110mm. Le placement en face arrière des capacités 30 permet de répondre à cette contrainte.

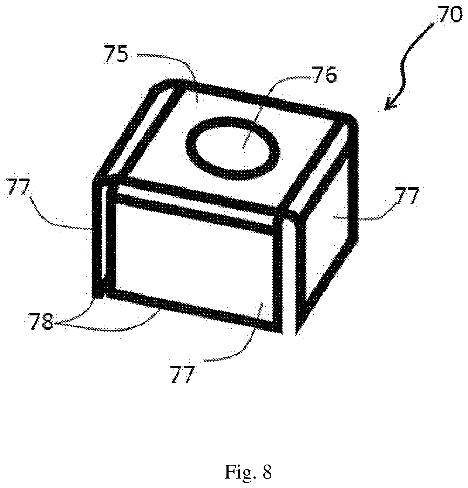

La figure 8 présente une pièce intermédiaire 10 selon un mode de réalisation, lorsque la piste de cuivre passe à proximité, plus particulièrement autour, du trou débouchant 46 du substrat métallique isolé 11. Cette pièce intermédiaire 10 selon un mode de réalisation de l'invention prend la forme d'un chapeau de soudure 70, permettant donc de faire l'interface entre le substrat métallique isolé 11 et la capacité 30 à souder.

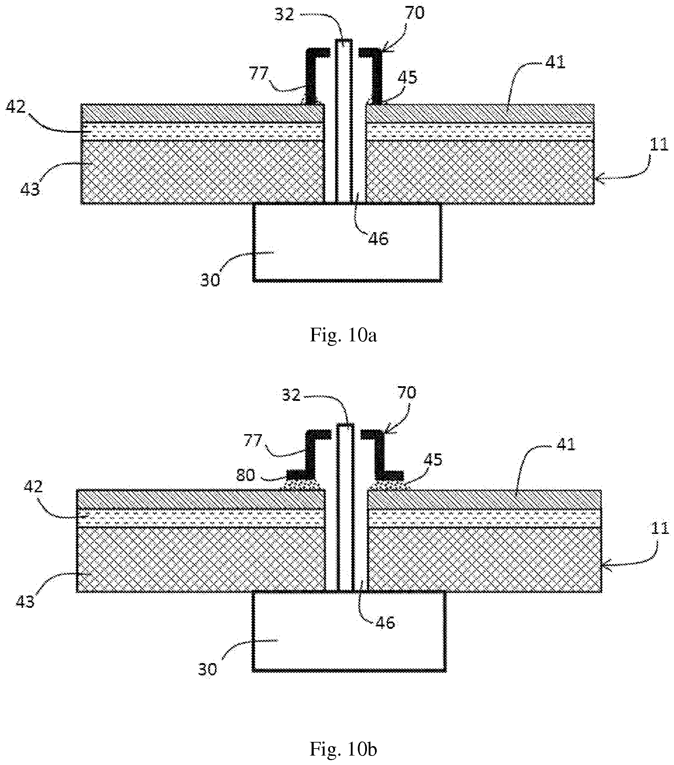

Comme le montre la figure 8, le chapeau de soudure 70 a une forme parallélépipédique. Il comprend une face supérieure 75 présentant une ouverture 76 destinée à recevoir un élément de connexion, tel qu'une fiche, et quatre parois 77 adjacentes dont les bords inférieurs 78 sont destinés à être soudés sur la piste 41 du substrat métallique isolé 11 comme le montre schématiquement la figure 10a.

Le chapeau de soudure 70 est soudé sur le substrat métallique isolé 11 de la même manière qu'un composant électronique de type CMS, c'est-à-dire qu'il est déposé sur le substrat métallique isolé 11, pourvu de pâte à braser après sérigraphie, par une machine de type « pick'n place », et qu'il est ensuite passé dans un four de refusions pour former une brasure entre les bords inférieurs et la piste.

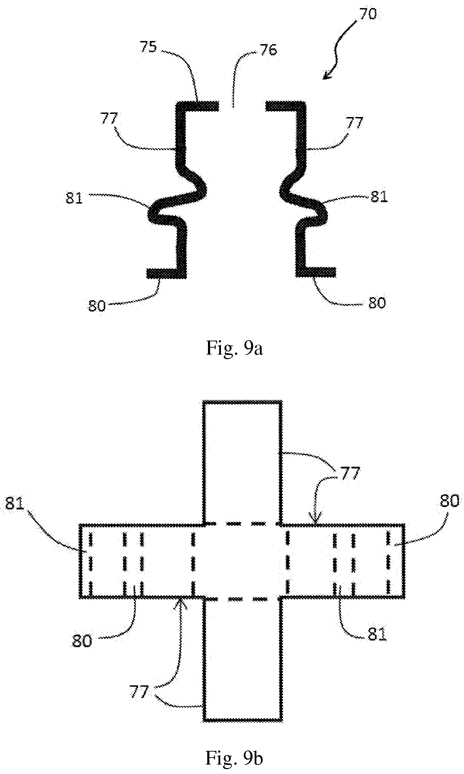

Des formes spécifiques sont définies pour faciliter le brasage du chapeau de soudure 70 sur le substrat métallique isolé 11, tel qu'un rajout d'une bride 80 sur une partie inférieure du chapeau de soudure 70, comme le montre la figure 9a, afin d'augmenter la surface mouillée par la brasure comme le montre la figure 10b.

Des zones de souplesse, formées par au moins un pli dans les parois, permettent aussi avantageusement une dilatation différentielle des éléments de connexion de la capacité.

Un chapeau de soudure 70, de forme générale simple, parallélépipédique ou cubique, est réalisé facilement par pliage d'une ébauche, obtenue par poinçonnage d'une tôle métallique, telle que celle montrée schématiquement sur la figure 9b. De cette façon, la bride et les zones de souplesse sont aussi facilement réalisées.

Les chapeaux de soudure 70 ayant été soudés sur le substrat métallique isolé 11 en regard de trous débouchants 44 réalisés dans le substrat métallique isolé 11 aux emplacements prévus pour recevoir les capacités 30, ces capacités 30 sont mis en place sous le substrat métallique isolé 11 en engageant leurs fiches 32 dans ces trous débouchants 46, et dans l'ouverture 76 des chapeaux de soudure 70.

Comme le montrent bien les figures 10a et 10b, la largeur de ces trous débouchants 46 est largement supérieure au diamètre de la broche de connexion pour éviter tout risque de court-circuit entre la fiche de connexion et le substrat métallique isolé 11.

L'invention n'est pas limitée aux modes de réalisation particuliers qui ont été décrits ci-dessus, de nombreuses variantes pouvant être conçues sans sortir de la portée définie par les revendications jointes.

## Revendications

1. Convertisseur de puissance de courant continue en courant alternatif, ledit convertisseur comprenant une carte électronique de puissance (54) réalisée sur un substrat métallique isolé (11) comprenant :
- un support métallique formant face arrière dudit substrat métallique isolé (11), et
- une couche d'isolant recouvrant le support métallique, formant face avant dudit substrat métallique isolé (11),
le convertisseur comprenant en outre au moins un composant (30) monté sur la face arrière du substrat métallique isolé (11),
**caractérisé en ce que** ledit composant (30) comprend au moins une fiche qui traverse le substrat métallique isolé (11) par l'intermédiaire d'un trou débouchant (46) dans ledit substrat métallique isolé (11), et ledit composant (30) est soudé à au moins une piste de liaison électrique au moyen d'une pièce intermédiaire (10) placée en face avant dudit substrat métallique isolé (11) et permettant de faire l'interface entre ladite au moins une piste de liaison électrique et la fiche du composant (30).

2. Convertisseur selon la revendication 1, dans lequel ladite piste est disposée sur la couche d'isolant dudit substrat métallique isolé (11).

3. Convertisseur selon la revendication 1 ou 2, dans lequel la pièce intermédiaire (10) est un assemblage de deux jeux de barres de connexion électrique (14a, 14b) séparés par une pièce plastique (12).

4. Convertisseur selon la revendication 3, dans lequel le matériau de la pièce plastique (12) est choisi de telle sorte que la pièce plastique (12) résiste à des températures de four de refusions.

5. Convertisseur selon la revendication 3 ou 4, dans lequel l'extrémité d'au moins une barre est en forme de fourche pour accueillir les fiches (32a, 32b) du composant (30).

6. Convertisseur selon la revendication 1 ou 2, dans lequel la pièce intermédiaire (10) est un chapeau de soudure (70) engagé par une ouverture (76) sur la fiche (32) du au moins un composant (30).

7. Convertisseur selon la revendication 6, dans lequel ledit chapeau de soudure (70) est de forme sensiblement parallélépipédique.

8. Convertisseur selon la revendication 6 ou 7, dans lequel ledit chapeau de soudure (70) comporte une partie inférieure (78) présentant une bride (80) s'étendant dans le plan dudit substrat métallique isolé (11).

9. Convertisseur selon l'une des revendications 6 à 8, dans lequel ledit chapeau de soudure (70) comporte une paroi (77) présentant au moins un pli (81).

10. Convertisseur selon l'une des revendications précédentes, dans lequel la piste de liaison électrique est une piste de cuivre.

11. Un compresseur de suralimentation électrique (70) comprenant un convertisseur de puissance de courant continu en courant alternatif tel que décrit dans les revendications précédentes.

## Patentansprüche

1. Gleichstrom/Wechselstromwandler, wobei der Wandler eine elektronische Karte (54) umfasst, die auf einem isolierten Metallsubstrat (11) hergestellt ist, umfassend:
- einen Metallträger, der die Rückseite des isolierten Metallsubstrats (11) bildet, und
- eine Isolierschicht, die den Metallträger bedeckt und die Vorderseite des isolierten Metallsubstrats (11) bildet,
wobei der Wandler außerdem mindestens eine Komponente (30) umfasst, die auf der Rückseite des isolierten Metallsubstrats (11) gebildet ist,
**dadurch gekennzeichnet, dass** die Komponente (30) mindestens einen Stecker umfasst, der das isolierte Metallsubstrat (11) durch ein Loch (46) durchquert, das in das isolierte Metallsubstrat (11) mündet, und die Komponente (30) an mindestens eine elektrische Verbindungsbahn mit Hilfe eines Zwischenstücks (10) gelötet ist, das gegenüber vor dem isolierten Metallsubstrat (11) platziert ist und ermöglicht, eine Schnittstelle zwischen der mindestens einen elektrischen Verbindungsbahn und dem Stecker der Komponente (30) zu bilden.

2. Wandler nach Anspruch 1,
wobei die Bahn auf der Isolierschicht des isolierten Metallsubstrats (11) angeordnet ist.

3. Wandler nach Anspruch 1 oder 2,
wobei das Zwischenstück (10) eine Anordnung von zwei Schienensätzen (14a, 14b) der elektrischen Verbindung ist, die durch ein Kunststoffstück (12) getrennt sind.

4. Wandler nach Anspruch 3,
wobei das Material des Kunststoffstücks (12) derart ausgewählt ist, dass das Kunststoffstück (12) Temperaturen eines Umschmelzofens standhält.

5. Wandler nach Anspruch 3 oder Anspruch 4,
wobei das Ende mindestens einer Schiene in der Form einer Gabel ist, um die Stecker (32a, 32b) der Komponente (30) aufzunehmen.

6. Wandler nach Anspruch 1 oder 2,
wobei das Zwischenstück (10) eine Lötkappe (70) ist, die durch eine Öffnung (76) mit dem Stecker (32) der mindestens einen Komponente (30) in Eingriff steht.

7. Wandler nach Anspruch 6,
wobei die Lötkappe (70) im Wesentlichen die Form eines Parallelepipeds aufweist.

8. Wandler nach Anspruch 6 oder 7,
wobei die Lötkappe (70) einen unteren Teil (78) umfasst, welcher einen Flansch (80) aufweist, der sich in der Ebene des isolierten Metallsubstrats (11) erstreckt.

9. Wandler nach einem der Ansprüche 6 bis 8,
wobei die Lötkappe (70) eine Wand (77) umfasst, die mindestens eine Falte (81) aufweist.

10. Wandler nach einem der vorhergehenden Ansprüche,
wobei die elektrische Verbindungsbahn eine Kupferbahn ist.

11. Lader (70), umfassend einen Gleichstrom/Wechselstromwandler, wie in den vorhergehenden Ansprüchen beschrieben.

## Claims

1. DC-to-AC power converter, said converter comprising an electronic power board (54) made on an insulated metal substrate (11) comprising:
- a metal carrier forming the back face of said insulated metal substrate (11); and
- an insulating layer covering the metal carrier, forming the front face of said insulated metal substrate (11),
the converter further comprising at least one component (30) mounted on the back face of the insulated metal substrate (11),
**characterized in that** said component (30) comprises at least one connector that passes through the insulated metal substrate (11) via a through-hole (46) in said insulated metal substrate (11), and said component (30) is soldered to at least one electrical connection track by means of an intermediate part (10) placed on the front face of said insulated metal substrate (11) and allowing an interface to be made between said at least one electrical connection track and the connector of the component (30).

2. Converter according to Claim 1, wherein said track is positioned on the insulating layer of said insulated metal substrate (11).

3. Converter according to Claim 1 or 2, wherein the intermediate part (10) is an assembly of two electrical connection busbars (14a, 14b) that are separated by a plastic part (12).

4. Converter according to Claim 3, wherein the material of the plastic part (12) is chosen such that the plastic part (12) withstands reflow oven temperatures.

5. Converter according to Claim 3 or 4, wherein the end of at least one busbar is fork-shaped so as to accommodate the connectors (32a, 32b) of the component (30)

6. Converter according to Claim 1 or 2, wherein the intermediate part (10) is a solder cap (70) that is placed, via an opening (76), over the connector (32) of the at least one component (30).

7. Converter according to Claim 6, wherein said solder cap (70) is substantially parallelepipedal in shape.

8. Converter according to Claim 6 or 7, wherein said solder cap (70) includes a lower portion (78) having a flange (80) extending in the plane of said insulated metal substrate (11).

9. Converter according to one of Claims 6 to 8, wherein said solder cap (70) includes a wall (77) having at least one fold (81).

10. Converter according to one of the preceding claims, wherein the electrical connection track is a copper track.

11. An electric supercharger (70) comprising a DC-to-AC power converter such as described in the preceding claims.
